(19) Europäisches Patentamt
European Patent Office
Office européen des brevets

(11) EP 4 398 006 A1

(12) EUROPEAN PATENT APPLICATION
published in accordance with Art. 153(4) EPC

(43) Date of publication:
10.07.2024 Bulletin 2024/28

(51) International Patent Classification (IPC):
G02B 5/30 (2006.01)          G02B 5/02 (2006.01)
B32B 7/023 (2019.01)         B32B 7/12 (2006.01)
H10K 59/00 (2023.01)         H10K 50/80 (2023.01)
H05B 33/02 (2006.01)

(21) Application number: 22881433.1

(22) Date of filing: 17.10.2022

(52) Cooperative Patent Classification (CPC):
B32B 7/023; B32B 7/12; G02B 5/02; G02B 5/30;
H05B 33/02; H10K 50/80; H10K 59/00

(86) International application number:
PCT/KR2022/015762

(87) International publication number:
WO 2023/063806 (20.04.2023 Gazette 2023/16)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 15.10.2021  KR 20210137841
30.06.2022  KR 20220080538

(71) Applicant: LG Chem, Ltd.
Yeongdeungpo-gu
Seoul 07336 (KR)

(72) Inventors:
• YUN, Ha Song
Daejeon 34122 (KR)
• KWON, Yoon Kyung
Daejeon 34122 (KR)
• CHOI, Jin Hyeon
Daejeon 34122 (KR)

(74) Representative: Plasseraud IP
66, rue de la Chaussée d'Antin
75440 Paris Cedex 09 (FR)

(54) **POLARIZING PLATE AND USE THEREOF**

(57)    The present application relates to a polarizing plate and a use thereof. The present application provides a polarizing plate capable of improving the problem of occurrence of rainbow stains in the appearance of an OLED display device, and exhibiting excellent visual appreciation, excellent hardness, and excellent heat-resistance and moisture-and-heat-resistance durability, and an OLED display device comprising the polarizing plate.

[Figure 1]

**Description**

[Technical Field]

The present application relates to a polarizing plate and a use thereof.

[Background Art]

In order to improve luminance of an OLED (organic light emitting diode) display device, various methods for improving the performance of an OLED display panel have been tried. However, when the luminance of the OLED display panel is increased, a rainbow stain phenomenon, which has not previously occurred, is intensified, whereby there may be a problem that the appearance visual appreciation of the OLED display device deteriorates due to the stain phenomenon.

[Prior Art Documents]

[Patent Documents]

(Patent Document 1) Korean Unexamined Patent Publication No. 10-2009-0122138

[Disclosure]

[Technical Problem]

The present application provides a polarizing plate capable of improving the problem of occurrence of rainbow stains in the appearance of an OLED display device, and exhibiting excellent visual appreciation, excellent hardness, and excellent heat-resistance and moisture-and-heat-resistance durability, and an OLED display device comprising the polarizing plate.

[Technical Solution]

The present application relates to a polarizing plate. The polarizing plate may comprise a polarizer and a scattering pressure-sensitive adhesive layer present on one side of the polarizer.
In this specification, the pressure-sensitive adhesive layer may be, for example, a layer of a pressure-sensitive adhesive composition. In this specification, the term "layer of the pressure-sensitive adhesive or adhesive composition" may mean a layer formed by coating or curing the pressure-sensitive adhesive or adhesive composition. The term "curing of the pressure-sensitive adhesive or adhesive composition" may mean implementing a cross-linked structure in the pressure-sensitive adhesive or adhesive composition through physical or chemical action or reaction of components included in the pressure-sensitive adhesive or adhesive composition. The curing can be induced by performing, for example, maintenance at room temperature, moisture application, heat application, active energy ray irradiation, or two or more processes of the foregoing together, and in each case, the pressure-sensitive adhesive or adhesive composition in a type that the curing is induced may be referred to as, for example, a room temperature curing pressure-sensitive adhesive or adhesive composition, a moisture-curing pressure-sensitive adhesive or adhesive composition, a heat-curing pressure-sensitive adhesive or adhesive composition, an active energy ray-curing pressure-sensitive adhesive or adhesive composition or a hybrid curing pressure-sensitive adhesive or adhesive composition.
In this specification, the scattering pressure-sensitive adhesive layer may mean a pressure-sensitive adhesive layer comprising scattering particles that may cause haze in the pressure-sensitive adhesive layer. The scattering particles may be, for example, beads to be described below.
The polarizing plate comprising the scattering pressure-sensitive adhesive layer may have a haze of 12% or more. The haze does not mean the haze of the scattering pressure-sensitive adhesive layer itself, which may mean the haze of the polarizing plate comprising the scattering pressure-sensitive adhesive layer and the polarizer. When the polarizing plate further comprises functional layers such as a protective film, a retardation layer, or a hard layer, as described below, it may mean a haze of the polarizing plate comprising the scattering pressure-sensitive adhesive layer, the polarizer, and the functional layers. The haze may be, specifically, 12% or more, 14% or more, 16% or more, 18% or more, 20% or more, 21% or more, 22% or more, 23% or more, 24% or more, 25% or more, 26% or more, 27 % or more 28% or more, 29% or more, 30% or more, 31% or more, 32% or more, 33% or more, 34% or more, 35% or more, 36% or more, 37% or more, 38% or more, 39% or more, or 40% or more, and may be 50% or less, 48% or less, 46% or less, 44% or less, 42% or less, 40% or less, 38% or less, 36% or less, 34% or less, 32% or less, 30% or less, 28% or less, 26% or less, 24% or less, 22% or less, or 20% or less. The haze of the polarizing plate may be a value measured based on a D65 light source. The haze of the polarizing plate may be a value measured for light having a wavelength of about 380 nm to 780 nm. The haze may be an average haze value measured for light having a wavelength of about 380 nm to 780 nm. When the haze of the polarizing plate is within the above range, it may be advantageous for improving the problem of occurrence of rainbow stains on the appearance of the OLED display device, and exhibiting excellent visual appreciation, excellent hardness, and excellent heat-resistance and moisture-and-heat-resistance durability.

The scattering pressure-sensitive adhesive layer may have a storage elastic modulus of 120,000 Pa or more at a temperature of 25°C and a frequency of 1 rad/sec. Specifically, the storage elastic modulus may be 125,000 Pa or more, 130,000 Pa or more, 135,000 Pa or more, 140,000 Pa or more, 145,000 Pa or more, 150,000 Pa or more, 151,000 Pa or more, 152,000 Pa or more, 153,000 Pa or more, or 154,000 Pa or more. The upper limit of the storage elastic modulus may be, for example, 200,000 Pa or less, 190,000 Pa or less, 180,000 Pa or less, 170,000 Pa or less, 160,000 Pa or less, 155,000 Pa or less, or 153,000 Pa or less. When the storage elastic modulus of the scattering pressure-sensitive adhesive layer is within the above range, it may be advantageous for improving the problem of occurrence of rainbow stains on the appearance of the OLED display device, and exhibiting excellent visual appreciation, excellent hardness, and excellent heat-resistance and moisture-and-heat-resistance durability.

The scattering pressure-sensitive adhesive layer may comprise a pressure-sensitive adhesive resin. In one example, the pressure-sensitive adhesive resin may be an acrylic resin. The acrylic resin may be a polymer capable of exhibiting adherence properties before or after cross-linking while comprising an acrylic monomer as a main component. In this specification, the matter of comprising an acrylic monomer as a main component may mean that the acrylic monomer is included in 80 wt% or more, 85 wt% or more, 90 wt% or more, 95 wt% or more, or 99 wt% or more among all monomers constituting the pressure-sensitive adhesive resin.

The pressure-sensitive adhesive resin may have an IPN (interpenetrating network) cross-linked structure. In this specification, the IPN cross-linked structure may mean a state where two or more cross-linked structures are simultaneously implemented in the pressure-sensitive adhesive layer. The two or more cross-linked structures in the IPN may exist, for example, in a state where they are entangled to each other (entanglement), a state where they are physically or chemically linked with each other, or a state where they penetrate each other.

The IPN cross-linked structure may comprise a first cross-linked structure formed by a cross-linking reaction of a cross-linkable polymer and a polyfunctional cross-linking agent, and a second cross-linked structure formed by a polymerization reaction of a radically polymerizable compound. The polymerization reaction of the radically polymerizable compound may be induced by a polymerization initiator. In order for the pressure-sensitive adhesive layer to have the IPN cross-linked structure, the pressure-sensitive adhesive composition for forming the pressure-sensitive adhesive layer may comprise a cross-linkable polymer, a polyfunctional cross-linking agent, a radically polymerizable compound, and a polymerization initiator. In this specification, the polyfunctional cross-linking agent may mean a cross-linking agent containing two or more cross-linkable functional groups.

In one example, the first cross-linked structure may be a cross-linked structure formed by application of heat, and the second cross-linked structure may be a cross-linked structure formed by irradiation of active energy rays. Here, in the category of "active energy rays", microwaves, infrared rays (IR), ultraviolet rays (UV), X-rays and gamma rays, as well as particle beams such as alpha-particle beams, proton beams, neutron beams or electron beams, and the like may be included, where they may be typically ultraviolet rays or electron beams, and the like.

In this specification, the "cross-linkable polymer" may mean a polymer to which a cross-linkable functional group capable of reacting with a polyfunctional cross-linking agent is imparted. Here, the cross-linkable functional group and the cross-linking agent may be selected so that they may react with each other by a reaction other than the radical reaction to implement a cross-linked structure, and for example, they may react by a drying or aging process to form a cross-linked structure.

The cross-linkable polymer may have, for example, a weight average molecular weight of 1,000,000 or less. Here, the weight average molecular weight means a polystyrene conversion value measured by GPC (gel permeation chromatography). The lower limit of the weight average molecular weight of the polymer is not particularly limited, which may be adjusted, for example, in the range of 200,000, or 300,000 or more.

The cross-linkable polymer may comprise a polymerized unit derived from a (meth)acrylic acid ester monomer. In this specification, the term "monomer" may mean all kinds of compounds capable of forming polymers through a polymerization reaction, and the polymer comprising a polymerized unit derived from a certain monomer may mean a polymer formed by polymerization of the certain monomer.

As the (meth)acrylic acid ester compound, for example, alkyl (meth)acrylate may be used. As the alkyl (meth)acrylate, for example, alkyl (meth)acrylate having an alkyl group with 1 to 20 carbon atoms, 1 to 14 carbon atoms, 1 to 12 carbon atoms, 1 to 8 carbon atoms, or 1 to 4 carbon atoms may be used, in consideration of control of the cohesive force, glass transition temperature and adherence properties, and the like. Here, the alkyl group may be, for example, a linear alkyl group, a branched alkyl group, or a cyclic alkyl group. An example of such a monomer may include methyl acrylate, ethyl acrylate, n-propyl acrylate, isopropyl acrylate, n-butyl acrylate, sec-butyl acrylate, 2-methylhepsyl acrylate, pentyl acrylate, 2-ethylhexyl (meth)acrylate, 2-ethylbutyl (meth)acrylate, n-octyl (meth)acrylate, isobornyl (meth)acrylate, isooctyl (meth)acrylate, isononyl (meth)acrylate and lauryl (meth)acrylate, and the like, and one or two or more of the foregoing may be appropriately selected and used.

The cross-linkable polymer may further comprise a polymerization unit derived from a copolymerizable monomer having a cross-linkable functional group (hereinafter, may be referred to as a cross-linkable monomer). In this specification, the copolymerizable monomer having a cross-linkable functional group may mean, for example, a compound, such as the (meth)acrylic acid ester monomer, having a moiety that can be copolymerized with another monomer included in the polymer, and also having a cross-linkable functional group, and thus being capable of imparting the cross-linkable functional group to the polymer. The cross-linkable functional group may be exemplified by a hydroxyl group, a carboxyl group, an isocyanate group, a glycidyl group, an amine group, an alkoxysilyl group or a vinyl group, and the like, and in general, a hydroxyl group or a carboxyl group, and the like may be used.

As the cross-linkable monomer, a copolymerizable monomer having a hydroxyl group may be used. As the copolymerizable monomer having a hydroxyl group, hydroxyalkyl (meth)acrylate such as 2-hydroxyethyl (meth)acrylate, 2-hydroxypropyl (meth)acrylate, 4-hydroxybutyl (meth)acrylate, 6-hydroxyhexyl (meth)acrylate or 8-hydroxyoctyl (meth)acrylate, or hydroxyalkylene glycol (meth)acrylate such as 2-hydroxyethylene glycol (meth)acrylate or 2-hydroxypropylene glycol (meth)acrylate, and the like may be used. According to one example of the present application, hydroxyalkyl acrylate or hydroxyalkylene glycol acrylate, and the like may be used among such monomers in consideration of control easiness of the reactivity with other monomers, or the glass transition temperature, and the like.

In one example, the cross-linkable polymer may comprise a polymerization unit derived from 80 parts by weight to 99 parts by weight of the (meth)acrylic acid ester monomer and 1 part by weight to 20 parts by weight of the cross-linkable monomer. In another example, the cross-linkable polymer may comprise a polymerization unit derived from 80 parts by weight to 99 parts by weight of the (meth)acrylic acid ester monomer and 1 part by weight to 10 parts by weight of the cross-linkable monomer. In another example, the cross-linkable polymer may comprise a polymerization unit derived from 90 parts by weight to 99 parts by weight of the (meth)acrylic acid ester monomer and 1 part by weight to 10 parts by weight of the cross-linkable monomer. In this range, the pressure-sensitive adhesive layer may implement an appropriate cross-linked structure.

The cross-linkable polymer may further comprise, for example, other optional comonomers, if necessary, for control of appropriate physical properties, and the like. The comonomer may include an alkylene oxide group-containing monomer such as alkoxyalkylene glycol (meth)acrylic acid ester, alkoxydialkylene glycol (meth)acrylic acid ester, alkoxytrialkylene glycol (meth)acrylic acid ester, alkoxytetraalkylene glycol (meth)acrylic acid ester, alkoxypolyethylene glycol (meth)acrylic acid ester, phenoxyalkylene glycol (meth)acrylic acid ester, phenoxydialkylene glycol (meth)acrylic acid ester, phenoxytrialkylene glycol (meth)acrylic acid ester, phenoxytetraalkylene glycol (meth)acrylic acid ester or phenoxypolyalkylene glycol (meth)acrylic acid ester; styrene or a styrenic monomer such as methyl styrene; a glycidyl group-containing monomer such as glycidyl (meth)acrylate; or a carboxylic acid vinyl ester such as vinyl acetate, and the like, but is not limited thereto. One or two or more of these comonomers may be selected as an appropriate kind as needed, and included in the polymer. Such a comonomer may be included in the polymer in a ratio of 20 parts by weight or less, or 0.1 parts by weight to 15 parts by weight, relative to the total weight of other compounds used as polymerization units in the polymer.

A mixture of monomers obtained by selecting necessary monomers among the above-described monomers, and compounding the selected monomers in a desired ratio may be applied to a polymerization method such as solution polymerization, photo polymerization, bulk polymerization, suspension polymerization or emulsion polymerization to prepare a cross-linkable polymer.

The scattering pressure-sensitive adhesive layer may comprise a polyfunctional cross-linking agent (curing agent) that reacts with the cross-linkable polymer to implement a cross-linked structure.

A specific type of cross-linking agent that can be used in the present application is not particularly limited, which may be selected in consideration of the type of cross-linkable functional group included in the cross-linkable polymer. As the cross-linking agent, for example, a general cross-linking agent such as an isocyanate cross-linking agent, an epoxy cross-linking agent, an aziridine cross-linking agent and a metal chelate cross-linking agent may be used. For example, the isocyanate cross-linking agent may be used, without being limited thereto. A specific example of the isocyanate cross-linking agent may include one or more selected from the group consisting of tolylene diisocyanate, xylene diisocyanate, diphenylmethane diisocyanate, hexamethylene diisocyanate, isophorone diisocyanate, tetramethylxylene diisocyanate, naphthalene diisocyanate, and a reactant of any one of the foregoing with a polyol (e.g., trimethylol propane); a specific example of the epoxy cross-linking agent may include one or more selected from the group consisting of ethylene glycol diglycidyl ether, triglycidyl ether, trimethylolpropane triglycidyl ether, N,N,N',N'-tetraglycidyl ethylenediamine and glycerin diglycidyl ether; and a specific example of the aziridine cross-linking agent may include one or more selected from the group consisting of N,N'-toluene-2,4-bis(1-aziridinecarboxamide), N,N'-diphenylmethane-4,4'-bis(1-aziridinecarboxamide), triethylene melamine, bisisoprotaloyl-1-(2-methylaziridine), and tri-1-aziridinylphosphine oxide, without being limited thereto. In addition, here, a specific example of the metal chelate cross-linking agent may include a compound in which a polyvalent metal such as aluminum, iron, zinc, tin, titanium, antimony, magnesium and/or vanadium is coordinated with acetyl acetone or ethyl acetoacetate, and the like, without being limited thereto.

The cross-linking agent may be included in an amount of 0.01 parts by weight to 10 parts by weight or 0.01 parts by weight to 5 parts by weight relative to 100 parts by weight of the cross-linkable polymer. If the content of the cross-linking agent is less than 0.01 parts by weight, there is a risk that the cohesive force of the pressure-sensitive adhesive layer is lowered, and if it exceeds 10 parts by weight, there is a risk that endurance reliability reduction, such as occurrence of the delamination or lifting phenomenon, occurs.

The second cross-linked structure may be formed by a polymerization reaction of a radically polymerizable compound. That is, the pressure-sensitive adhesive layer may further comprise a polymer of a radically polymerizable polyfunctional compound having two or more, for example, 2 to 6 radically polymerizable functional groups, in order to implement the IPN structure, and also comprise a radical initiator for inducing polymerization of the radically polymerizable compound.

The type of the radically polymerizable compound is not particularly limited, and for example, a polyfunctional acrylate having 2 to 6 (meth)acryloyl groups as the radically polymerizable functional group may be used.

The type of polyfunctional acrylate is not particularly limited, which may include, for example, difunctional acrylates such as 1,4-butanediol di(meth)acrylate, 1,6-hexanediol di(meth)acrylate, neopentyl glycol di(meth)acrylate, polyethylene glycol di(meth)acrylate, neopentylglycol adipate di(meth)acrylate, hydroxyl pivalic acid neopentyl glycol di(meth)acrylate, dicyclopentanyl di(meth)acrylate, caprolactone-modified dicyclopentenyl di(meth)acrylate, ethylene oxide-modified di(meth)acrylate, di(meth)acryloxyethyl isocyanurate, allylated cylohexyl di(meth)acrylate, tricyclodecanedimethanol (meth)acrylate, dimethylol dicyclopentane di(meth)acrylate, ethylene oxide-modified hexahydrophthalic acid di(meth)acrylate, tricyclodecane dimethanol (meth)acrylate, neopentyl glycol-modified trimethylpropane di(meth)acrylate, adamantane di(meth)acrylate or 9,9-bis[4-(2-acryloyloxyethoxy)phenyl]fluorene; trifunctional acrylates such as trimethylolpropane tri(meth)acrylate, dipentaerythritol tri(meth)acrylate, propionic acid-modified dipentaerythritol tri(meth)acrylate, pentaerythritol tri(meth)acrylate, propylene oxide-modified trimethylolpropane tri(meth)acrylate, trifunctional urethane (meth)acrylate, or tris(meth)acryloxyethyl isocyanurate; tetrafunctional acrylates such as diglycerin tetra(meth)acrylate or pentaerythritol tetra(meth)acrylate; pentafunctional acrylates such as propionic acid-modified dipentaerythritol penta(meth)acrylate; and hexafunctional acrylates such as dipentaerythritol hexa(meth)acrylate, caprolactone-modified dipentaerythritol hexa(meth)acrylate or urethane (meth)acrylate (e.g., reactants of isocyanate monomers and trimethylol propane tri(meth)acrylate), but is not limited thereto.

In the present application, one or a mixture of two or more of such polyfunctional acrylates may be used, and in particular, it may be advantageous in terms of implementing durability to use an acrylate having a molecular weight of 5,000 or less, 4,000 or less, 3,000 or less, 2,000 or less, or 1,000 or less, and trifunctionality or more.

As the polyfunctional acrylate, a polyfunctional acrylate comprising a ring structure and/or a urethane bond in its molecular structure may be used. Here, the ring structure included in the acrylate is not particularly limited, which may be any of a carbocyclic structure or a heterocyclic structure; or a monocyclic or polycyclic structure. Specifically, an example of the ring structure included in the polyfunctional acrylate may include a cycloalkyl ring structure with 3 to 12 carbon atoms, preferably 3 to 8 carbon atoms, such as cyclopentane, cyclohexane or cycloheptane, wherein one or more, for example, 1 to 5, or 1 to 3 of the ring structures may be included in the acrylate, and one or more hetero atoms such as O, S or N may also be included.

A specific example of the polyfunctional acrylate having the ring structure may include a monomer having an isocyanurate structure, such as tris(meth)acryloxyethyl isocyanurate, isocyanurate-modified urethane acrylate (for example, reactants of isocyanate compounds (e.g., isoborone diisocyanate) having a ring structure and acrylate compounds (e.g., trimethylolpropane tri(meth)acrylate or pentaerythritol tri(meth)acrylate), etc.), and the like, but is not limited thereto.

The radically polymerizable compound in the scattering pressure-sensitive adhesive layer may be included in an amount of 3 parts by weight to 25 parts by weight relative to 100 parts by weight of the cross-linkable polymer. In this range, the IPN structure capable of securing suitable physical properties may be implemented.

The type of the radical initiator capable of inducing the polymerization reaction of the radically polymerizable compound is not particularly limited. For example, one or more selected from the group consisting of a photoinitiator and a thermal initiator may be used as the radical initiator, and, if necessary, the photoinitiator and the thermal initiator may also be used simultaneously. The initiator may be included, for example, in an amount of 0.1 parts by weight to 10 parts by weight relative to 100 parts by weight of the radically polymerizable compound, but is not limited thereto.

As the photoinitiator, any one capable of inducing a polymerization reaction of the above-described radically polymerizable compound in a curing process by light irradiation or the like to implement the second cross-linked structure may be used. For example, benzoin-based, hydroxy ketone-based, aminoketone-based or phosphine oxide-based photoinitiators may be used, and specifically, it may include benzoin, benzoin methyl ether, benzoin ethyl ether, benzoin isopropyl ether, benzoin n-butyl ether, benzoin isobutyl ether, acetophenone, dimethylanino acetophenone, 2,2-dimethoxy-2-phenylacetophenone, 2,2-diethoxy-2-phenylacetophenone, 2-hydroxy-2-methyl-1-phenylpropan-lone, 1-hydroxycyclohexylphenylketone, 2-methyl-1-[4-(methylthio)phenyl]-2-morpholino-propane-1-one, 4-(2-hydroxyethoxy)phenyl-2-(hydroxy-2-propyl)ketone, benzophenone, p-phenylbenzophenone, 4,4-diethylaminobenzophenone, dichlorobenzophenone, 2-methylanthraquinone, 2-ethylanthraquinone, 2-t-butylanthraquinone, 2-aminoanthraquinone, 2-methylthioxanthone, 2-ethylthioxanthone, 2-chlorothioxanthone, 2,4-dimethylthioxanthone, 2,4-diethylthioxanthone, benzyldimethylketal, acetophenone dimethylketal, p-dimethylaminobenzoic acid ester, oligo[2-hydroxy-2-methyl-1-[4-(1-methylvinyl)phenyl]propanone] and 2,4,6-trimethylbenzoyl-diphenyl-phosphine oxide, and the like. In the present application, one, or two or more of the foregoing may be used, but is not limited thereto.

Also, the thermal initiator is not particularly limited, which may be appropriately selected in consideration of the physical properties to be implemented. For example, a thermal initiator having a 10-hour half-life temperature of 40°C or more and less than 100°C may be used. By setting the half-life temperature of the thermal initiator as above, the pot-life may be sufficiently secured, and the drying temperature for decomposition of the thermal initiator may also be properly maintained.

The type of the thermal initiator is not particularly limited as long as it has the above-described physical properties, and for example, a conventional initiator such as an azo-based compound, a peroxide-based compound, or a redox-based compound may be used. Here, an example of the azo-based compound may include 2,2-azobis(2-methylbutyronitrile), 2,2-trilazobis(isobutyronitrile), 2,2-trilazobis(2,4-dimethylvaleronitrile), 2,2-nitazobis-2-hydroxymethylpropionitrile, dimethyl-2,2-methylazobis(2-methylpropionate) and 2,2-pioazobis(4-methoxy-2, 4-dimethylvaleronitrile), and the like; an example of the peroxide-based compound may include inorganic peroxides such as potassium perlactate, ammonium persulfate or hydrogen peroxide; or organic peroxides such as diacyl peroxide, peroxy dicarbonate, peroxy ester, tetramethylbutylperoxy neodecanoate (e.g., Perocta ND, manufactured by NOF), bis(4-butylcyclohexyl)peroxydicarbonate (e.g., Peroyl TCP, manufactured by NOF), di(2-ethylhexyl)peroxy carbonate, butylperoxy neodecanoate (e.g., Perbutyl ND, manufactured by NOF), dipropyl peroxydicarbonate (e.g., Peroyl NPP, manufactured by NOF), diisopropyl peroxy dicarbonate (e.g., Peroyl IPP, manufactured by NOF), diethoxyethyl peroxy dicarbonate (e.g., Peroyl EEP, manufactured by NOF), diethoxyhexyl peroxy dicarbonate (e.g., Peroyl OEP, manufactured by NOF), hexyl peroxy dicarbonate (e.g., Perhexyl ND, manufactured by NOF), dimethoxybutyl peroxy dicarbonate (e.g., Peroyl MBP, manufactured by NOF), bis(3-methoxy-3-methoxybutyl) peroxy dicarbonate (e.g., Peroyl SOP, manufactured by NOF), dibutyl peroxydicarbonate, dicetyl peroxy dicarbonate, dimyristyl peroxy dicarbonate, 1,1,3,3-tetramethylbutyl peroxypivalate, hexyl peroxypivalate (e.g., Perhexyl PV, manufactured by NOF), butyl peroxy pivalate (e.g., Perbutyl, manufactured by NOF), trimethyl hexanoyl peroxide (e.g., Peroyl 355, manufactured by NOF), dimethyl hydroxybutyl peroxyneodecanoate (e.g., Luperox 610M75, manufactured by Atofina), amyl peroxyneodecanoate (e.g, Luperox 546M75, manufactured by Atofina), butyl peroxyneodecanoate (e.g., Luperox 10M75, manufactured by Atofina), t-butylperoxy neoheptanoate, amylperoxy pivalate (e.g, Luperox 546M75, manufactured by Alofina), t-butylperoxy pivalate, t-amyl peroxy-2-ethylhexanoate, lauryl peroxide, dilauroyl peroxide, didecanoyl peroxide, benzoyl peroxide or dibenzoyl peroxide; and an example of the redox-based compound may include a mixture of a peroxide compound and a reducing agent in combination, and the like, without being limited thereto. In the present application, one or a mixture of two or more of such azo-based, peroxide-based, or redox-based compounds may be used.

In addition to the above-described components, the scattering pressure-sensitive adhesive layer may further comprise, if necessary, one or more additives selected from the group consisting of an antistatic agent, a silane coupling agent, a tackifying resin, an epoxy resin, an ultraviolet stabilizer, an antioxidant, a colorant, a reinforcing agent, a filler, an antifoaming agent, a surfactant, and a plasticizer as well-known.

The scattering pressure-sensitive adhesive layer may further comprise beads. The storage elastic modulus of the scattering pressure-sensitive adhesive layer and the haze of the polarizing plate may mean the storage elastic modulus of the pressure-sensitive adhesive layer and the haze of the polarizing plate in a state where the beads are included. The refractive index of the beads may be different from the refractive index of the cross-linkable polymer and/or the polymer of the radically polymerizable compound. The pressure-sensitive adhesive layer comprises the beads, thereby imparting to the pressure-sensitive adhesive layer, so that it is possible to improve visibility of rainbow stains that may occur during manufacturing of an OLED display device.

In one example, the difference (A-B) between the refractive index (A) of the cross-linkable polymer and the refractive index (B) of the beads may be 0.05 or more. The greater the refractive index difference of the cross-linkable polymer and the beads, the more advantageous it is to relatively implement the haze, so that a high haze may be implemented even with a small amount. The upper limit of the refractive index difference (A-B) may be, for example, 0.1 or less. The refractive index is a value measured for a light source having a wavelength of 350 nm to 1450 nm at a temperature of 25°C using an Abbe refractometer. When the refractive index difference is too small, it is difficult to express a desired level of haze, and when the refractive index difference is too large, the optical properties may be deteriorated due to loss of light going straight, so that it may be appropriate that the refractive index difference is within the above range. In one example, the refractive index of the beads may be in the range of 1.415 to 1.425.

The content of the beads may be appropriately selected within a range that does not impair the purpose of the present application. In one example, the beads may be included in the range of 1 part by weight to 3 parts by weight when the weight of all the scattering pressure-sensitive adhesive components is 100 parts by weight. In this specification, the weight of all the scattering pressure-sensitive adhesive components may mean the total weight of all cross-linkable polymers, radically polymerizable compounds, cross-linking agents, initiators, additives and beads included in the scattering pressure-sensitive adhesive. Alternatively, in this specification, the weight of all components of the scattering pressure-sensitive adhesive layer may mean the sum of the weights of all components except for the solvent in the pressure-sensitive adhesive composition. More specifically, the beads may be included in an amount of 1 part by weight or more, 1.2 parts by weight or more, 1.4 parts by weight or more, 1.5 parts by weight or more, 1.6 parts by weight or more, or 1.8 parts by weight or more, and may be included in an amount of 3 parts by weight or less, 2.8 parts by weight or less, 2.6 parts by weight or less, 2.4 parts by weight or less, or 2.2 parts by weight or less, relative to 100 parts by weight of the all the components of the scattering pressure-sensitive adhesive. In another example, the beads may be included in an amount of 3 parts by weight or more relative to 100 parts by weight of the pressure-sensitive adhesive resin. Specifically, the beads may be included in an amount of 3.1 parts by weight or more, 3.2 parts by weight or more, 3.4 parts by weight or more, 3.6 parts by weight or more, 3.8 parts by weight or more, 4.0 parts by weight or more, 4.2 parts by weight or more, 4.4 parts by weight or more, 4.6 parts by weight or more, 4.8 parts by weight or more, 5.0 parts by weight or more, 5.2 parts by weight or more, 5.4 parts by weight or more, 5.6 parts by weight or more, 5.8 parts by weight or more, or 6.0 parts by weight or more, and may be included in an amount of 10 parts by weight or less, 9.5 parts by weight or less, 9 parts by weight or less, 8.5 parts by weight or less, 8 parts by weight or less, 7.5 parts by weight or less, 7 parts by weight or less, 6.5 parts by weight or less, 6 parts by weight or less, 5.5 parts by weight or less, 5 parts by weight or less, 4.5 parts by weight or less, 4 parts by weight or less, or 3.5 parts by weight or less, relative to 100 parts by weight of the pressure-sensitive adhesive resin. When the bead content is within the above range, it may be advantageous for improving the problem of occurrence of rainbow stains on the appearance of the OLED display device, and exhibiting excellent visual appreciation, excellent hardness, and excellent heat-resistance and moisture-and-heat-resistance durability. Meanwhile, when the bead content is too large, the camera recognizes the beads upon the attaching process and catches the reference line incorrectly, whereby attaching errors may occur.

In one example, the beads may be organic beads. The organic beads may comprise, for example, a silicone resin. The silicone resin may comprise, for example, silsesquioxane. The silsesquioxane may be a compound having a formula of $[RSiO_{3/2}]n$, where R=H, alkyl, aryl or alkoxy. In one example, the silicone resin may be polymethylsilsesquioxane.

In one example, the beads may be spherical particles. The size of the beads may be appropriately selected within a range that does not impair the purpose of the present application. In one example, the average particle diameter (D50) of the beads may be $6\mu m$ or less. Specifically, the average particle diameter (D50) of the beads may be $5.8\mu m$ or less, $5.6\mu m$ or less, $5.4\mu m$ or less, $5.2\mu m$ or less, $5.0\mu m$ or less, $4.8\mu m$ or less, $4.6\mu m$ or less, $4.4\mu m$ or less, $4.2\mu m$ or less, $4.0\mu m$ or less, $3.8\mu m$ or less, $3.6\mu m$ or less, $3.4\mu m$ or less, $3.2\mu m$ or less, $3.0\mu m$ or less, $2.9\mu m$ or less, $2.8\mu m$ or less, $2.7\mu m$ or less, 2. $\mu m$ or less, or $2.5\mu m$ or less. The average particle diameter (D50) of the beads may be, for example, 1 $\mu m$ or more, 1.5 $\mu m$ or more, 2.0 $\mu m$ or more, or 2.2 $\mu m$ or more. When the average particle diameter of the beads is within the above range, it may be advantageous for improving the problem of occurrence of rainbow stains on the appearance of the OLED display device, and exhibiting excellent visual appreciation, excellent hardness, and excellent heat-resistance and moisture-and-heat-resistance durability. Meanwhile, the average particle diameter (D50) of the beads may be $3\mu m$ or less, $2.5\mu m$ or less, or $2.0\mu m$ or less in terms of preventing the sparkling phenomenon and/or the camera recognition error upon the attachment process.

The thickness of the scattering pressure-sensitive adhesive layer may be in a range of $15\mu m$ to $25\mu m$. Specifically, the thickness of the scattering pressure-sensitive adhesive layer may be $16\mu m$ or more, $17\mu m$ or more, or $18\mu m$ or more, and may be $24\mu m$ or less, $23\mu m$ or less, or $22\mu m$ or less. When the thickness of the scattering pressure-sensitive adhesive layer is within the above range, it may be advantageous for improving the problem of occurrence of rainbow stains on the appearance of the OLED display device, and exhibiting excellent visual appreciation, excellent hardness, and excellent heat-resistance and moisture-and-heat-resistance durability.

The scattering pressure-sensitive adhesive layer may have an excellent hardness. In one example, the scattering pressure-sensitive adhesive layer may have a glass pushing distance of $210\mu m$ or less as measured at 800 gf for 1000 seconds. Specifically, the glass pushing distance may be $205\mu m$ or less, 200 $\mu m$ or less, 195 $\mu m$ or less, or 190 $\mu m$ or less. It means that the lower the glass pushing distance, the higher the hardness of the sample, and when the hardness of the pressure-sensitive adhesive layer is high, the resistance to external deformation is large, so that there is an advantage that deformation of the pressure-sensitive adhesive layer is minimized. The lower limit of the glass pushing distance may be, for example, $160\mu m$ or more, $170\mu m$ or more, $180\mu m$ or more, $190\mu m$ or more, or $195\mu m$ or more.

The polarizing plate may have excellent durability. In one example, the polarizing plate may have a haze change rate $\Delta Ha$ of Equation 1 after resisting heat and a haze change rate $\Delta Hb$ of Equation 2 after resisting moisture and heat of 2% or less, respectively. Specifically, the $\Delta Ha$ may be 1.8% or less, 1.6% or less, 1.4% or less, or 1.2% or less. Specifically, the $\Delta Hb$ may be 1.8% or less, 1.6% or less, 1.4% or less, 1.2% or less, 1.0% or less, 0.8% or less, 0.6% or less, or 0.4% or less.

[Equation 1]

$$\Delta Ha = (H_1 - H_2)/H_1 \times 100\%$$

[Equation 2]

$$\Delta Hb = (H_3 - H_4)/H_3 \times 100\%$$

In Equation 1, $H_1$ is the haze of the polarizing plate at a temperature of 25°C, and $H_2$ is the haze of the polarizing plate after storage at a temperature of 80°C for 500 hours. In Equation 2, $H_3$ is the haze of the polarizing plate at a temperature of 25°C, and $H_4$ is the haze of the polarizing plate after storage at a temperature of 60°C and 90% relative humidity for 500 hours.

In this specification, the term "polarizer" means a film, sheet, or element having a polarization function. The polarizer is a functional element capable of extracting light vibrating in one direction from incident light vibrating in multiple directions.

The polarizer may be an absorption type polarizer. In this specification, the absorption type polarizer means an element exhibiting selective transmission and absorption characteristics for incident light. The absorption type polarizer may transmit light vibrating in one direction from incident light vibrating in multiple directions and absorb light vibrating in the other directions.

The polarizer may be a linear polarizer. In this specification, the linear polarizer means a polarizer in which the selectively transmitting light is linearly polarized light vibrating in one direction and the selectively absorbing light is linearly polarized light vibrating in directions orthogonal to the vibration direction of the linearly polarized light.

As the polarizer, for example, a polarizer in which a stretched polymer film such as a stretched PVA film is dyed with iodine, or a guest-host type polarizer in which liquid crystals polymerized in an aligned state are used as a host, and an anisotropic dye arranged according to the orientation of the liquid crystals is used as a guest may be used, without being limited thereto.

The kind of polyvinyl alcohol resins or their derivatives for forming the PVA-based polarizer is not particularly limited, where all arbitrary PVA resins or derivatives thereof previously known to be capable of forming the PVA-based polarizer may be used without any particular limitation. However, a representative example of the PVA-based resin derivative may include polyvinyl formal resin or polyvinyl acetal resin, and the like. Furthermore, the PVA-based polarizer may also be formed using a commercially available PVA-based film generally used for manufacturing polarizers in the relevant technical field, for example, Kuraray's P30, PE30, and PE60, Japan Synthetic Company's M2000, M3000 and M6000, and the like.

The resin included in the PVA-based polarizer may have, for example, a polymerization degree in a range of about 1,000 to 10,000 or so, or 1,500 to 5,000. When the polymerization degree is within the above range, it may be advantageous for free molecular movement and flexibly mixing with iodine or a dichroic dye.

According to one example of the present application, a PVA stretched film may be used as the polarizer. The transmittance or polarization degree of the polarizer may be appropriately adjusted in consideration of the purpose of the present application. For example, the transmittance of the polarizer may be 42.5% to 55%, and the polarization degree may be 65% to 99.9997%. The transmittance and polarization degree may be values measured for light having a wavelength of about 550 nm.

In one example, it may further comprise a polarizer protective film present on one or both sides of the polarizer. The protective film may be attached to the polarizer via an adhesive layer.

As the polarizer protective film, a triacetyl cellulose (TAC)-based film, a cyclic olefin-based polymer (COP) film, a cyclic olefin-based copolymer (COC) film, or an acrylic film may be used. The polarizer protective film preferably exhibits high transparency with a light transmittance of 85% to 100% in consideration of excellent visibility and optical properties of the display device, and the like.

The polarizing plate may further comprise a surface treatment layer. The surface treatment layer may be formed on one side of the polarizer protective film. Specifically, the surface treatment layer may be formed on one side of the polarizer protective film located on the opposite side of the polarizer on which the scattering pressure-sensitive adhesive layer is formed. The surface treatment layer may be exemplified by, for example, a hard coating layer, a low reflection layer, an anti-glare layer, an anti-fingerprint layer, and the like, but is not limited thereto. The surface treatment layer may be disposed at the outermost portion of the polarizing plate.

The polarizer protective film may have a thickness in a range of $20\mu m$ to $100\mu m$. When the thickness of the polarizer protective film satisfies the above range, there is an effect of being capable of securing roll process workability while securing mechanical strength that can protect the polarizer.

The composition or formation method of the adhesive layer for attaching the polarizer and the protective film is not particularly limited, and any composition that has been previously used for bonding the polarizer and the protective film may be applied to form the adhesive layer. In one example, the adhesive layer may be a UV curing adhesive. In addition, the thickness of the adhesive layer may be 0.5μm to 4.0μm, and as the thickness of the adhesive layer satisfies such a range, good coating uniformity can be ensured.

The polarizing plate may further comprise a retardation layer between the polarizer and the scattering pressure-sensitive adhesive layer. The retardation layer may be, for example, a liquid crystal layer or a stretched polymer layer. The liquid crystal layer may comprise a polymerizable liquid crystal compound in a polymerized state. In this specification, the term "polymerizable liquid crystal compound" may mean a compound that includes a moiety capable of exhibiting liquid crystallinity, for example, a mesogen skeleton, and the like, and also includes one or more polymerizable functional groups. The polymerizable functional group may be, for example, an acryloyl group, a methacryloyl group, an acryloyloxy group or a methacryloyloxy group. As the stretched polymer layer, for example, a polymer layer comprising a polyolefin such as polyethylene or polypropylene, a cycloolefin polymer (COP) such as polynorbornene, polyvinyl chloride, polyacrylonitrile, polysulfone, an acrylic resin, polycarbonate, a polyester such as polyethylene terephthalate, polyacrylate, polyvinyl alcohol, or a cellulose ester-based polymer such as TAC (triacetyl cellulose), or a copolymer of two or more monomers among the monomers forming the polymer, and the like may be used.

The retardation layer may have, for example, a quarter-wavelength phase delay characteristic. In this specification, the term n-wavelength phase delay characteristic means a characteristic capable of phase-delaying incident light by n times the wavelength of the incident light within at least a part of a wavelength range. The quarter-wavelength phase delay characteristic may be a characteristic of converting incident linearly polarized light into elliptically polarized light or circularly polarized light, and conversely, converting incident elliptically polarized light or circularly polarized light into linearly polarized light. In one example, the retardation layer may have a planar phase difference for light with a wavelength of 550 nm in a range of 90 nm to 300 nm. In another example, the planar phase difference may be 100 nm or more, 105 nm or more, 110 nm or more, 115 nm or more, 120 nm or more, 125 nm or more, or 130 nm or more. In addition, the planar phase difference may be 290 nm or less, 280 nm or less, 270 nm or less, 260 nm or less, 250 nm or less, 240 nm or less, 230 nm or less, 220 nm or less, 210 nm or less, 200 nm or less, 190 nm or less, 180 nm or less, 170 nm or less, 160 nm or less, 150 nm or less, or 145 nm or less.

The polarizing plate may further comprise a hard layer between the polarizer and the scattering pressure-sensitive adhesive layer. As the hard layer, an adhesive layer may be exemplified. As the adhesive layer, a UV curing adhesive layer may be used. In addition, the thickness of the adhesive layer may be within the range of 0.5μm to 4.0μm, and as the thickness of the adhesive layer satisfies such a range, good coating uniformity may be ensured.

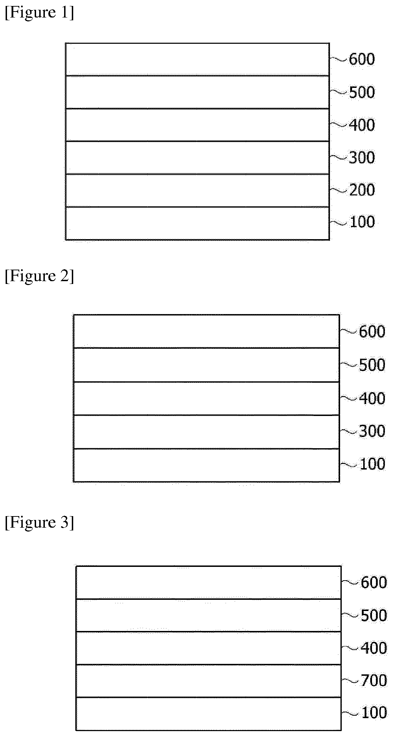

Figures 1 to 3 exemplarily show the structures of the polarizing plates of the present application, respectively. As shown in Figure 1, the polarizing plate may comprise a scattering pressure-sensitive adhesive layer (100), a retardation layer (200), a polarizer protective film (300), a polarizer (400), a polarizer protective film (500) and a surface treatment layer (600) sequentially. Alternatively, as shown in Figure 2, the polarizing plate may comprise a scattering pressure-sensitive adhesive layer (100), a polarizer protective film (300), a polarizer (400), a polarizer protective film (500) and a surface treatment layer (600) sequentially. Alternatively, as shown in Figure 3, it may comprise a scattering pressure-sensitive adhesive layer (100), a hard layer (700), a polarizer (400), a polarizer protective film (500) and a surface treatment layer (600) sequentially.

The polarizing plate may be provided in a state where the release film is attached to one side of the scattering pressure-sensitive adhesive layer, and such a release film may be removed when sticked to the display panel. The release film may serve to protect the scattering pressure-sensitive adhesive layer until the polarizing plate is bonded to the display panel. As the release film, a release film well known in the relevant technical field, for example, an acrylic film, a polyethylene terephthalate (PET) film, a triacetyl cellulose (TAC) film, a polynorbornene (PNB) film, a cycloolefin polymer (COP) film, a polycarbonate (PC) film or the like may be used, without being limited thereto.

The present application also relates to an OLED display device. The OLED display device may comprise an OLED display panel and the polarizing plate disposed on one side of the OLED display panel. At this time, one side of the scattering pressure-sensitive adhesive layer of the polarizing plate may be in direct contact with the OLED display panel. The polarizing plate may be disposed on the viewer side of the OLED display panel. When the polarizing plate of the present application is applied to an OLED display device, it may be advantageous for improving the problem of occurrence of rainbow stains on the appearance of the OLED display device, and exhibiting excellent visual appreciation, excellent hardness, and excellent heat-resistance and moisture-and-heat-resistance durability.

The OLED display panel may comprise a substrate, a lower electrode, an organic light emitting layer, and an upper electrode sequentially. The organic emission layer may comprise an organic material capable of emitting light when a voltage has been applied to the lower electrode and the upper electrode. Any one of the lower and upper electrodes may be a positive electrode (anode) and the other may be a negative electrode (cathode). The positive electrode is an electrode into which holes are injected, which may be made of a conductive material having a high work function, and the negative electrode is an electrode into which electrons are injected, which may be made of a conductive material having a low work function. In general, a transparent metal oxide layer such as ITO or IZO having a large work function may be used as the positive electrode, and a metal electrode having a low work function may be used as the negative electrode. In general, since the organic light emitting layer is transparent, a transparent display can be realized when the upper and lower electrodes are made transparent. In one example, when the thickness of the metal electrode is very thin, a transparent display may be realized.

The OLED display panel may further comprise an encapsulation substrate, which functions to prevent moisture and/or oxygen from being introduced from the outside, on the upper electrode. It may further comprise auxiliary layers between the lower electrode and the organic light emitting layer and between the upper electrode and the organic light emitting layer. The auxiliary layer may include a hole transporting layer, a hole injecting layer, an electron injecting layer, and an electron transporting layer for balancing electrons and holes, but is not limited thereto.

The polarizing plate may be disposed on a side from which light is emitted (light emission side) in the OLED display panel. For example, in the case of a bottom emission structure in which light is emitted toward a base substrate, it may be disposed on the outside of the base substrate, and in the case of a top emission structure in which light is emitted toward an encapsulation substrate, it may be disposed on the outside of the encapsulation substrate. When the polarizing plate comprises a retardation layer, it prevents external light from being reflected by a reflective layer made of metal such as electrodes and wirings of the OLED panel and coming out of the OLED panel, whereby it is possible to improve visibility and performance of the display device.

[Effects of Invention]

The present application relates to a polarizing plate and a use thereof. The present application provides a polarizing plate capable of improving the problem of occurrence of rainbow stains in the appearance of an OLED display device, and exhibiting excellent visual appreciation, excellent hardness, and excellent heat-resistance and moisture-and-heat-resistance durability, and an OLED display device comprising the polarizing plate.

[Brief Description of Drawings]

Figure 1 exemplarily shows a structure of a polarizing plate of the present application.

Figure 2 exemplarily shows a structure of a polarizing plate of the present application.

Figure 3 exemplarily shows a structure of a polarizing plate of the present application.

[Explanation of Reference Numerals]

100: scattering pressure-sensitive adhesive layer, 200: retardation layer, 300: polarizer protective film, 400: polarizer, 500: polarizer protective film, 600: surface treatment layer, 700: hard layer

[Mode for Invention]

Hereinafter, the present application will be specifically described through Examples according to the present application and Comparative Examples not according to the present application, but the scope of the present application is not limited by Examples presented below.

Example 1

100 parts by weight of a mixture (AD-705, LG Chem) of a cross-linkable polymer and a radically polymerizable trifunctional compound, 0.08 parts by weight of a curing agent (T-39M, Soken), 0.74 parts by weight of an initiator (AD-PI2, LG Chem), 0.05 parts by weight of a silane coupling agent (AD-M812, LG Chem), 0.28 parts by weight of an antistatic agent (HQ115, 3M), and 4 parts by weight of beads (Tospearl 145, Momentive) were put into a reaction vessel, and then a solvent (ethyl acetate) was introduced thereto in an amount of 20 parts by weight relative to 100 parts by weight of the cross-linkable polymer (AD-705) to prepare a pressure-sensitive adhesive composition. The cross-linkable polymer is a polymer of 99 parts by weight of BA (butyl acrylate) and 1 part by weight of 4-HBA (4-hydroxybutyl acrylate). The radically polymerizable trifunctional compound is a trifunctional acrylate. The beads comprise a silicone resin, and are spherical particles having an average particle diameter (D50) of about 4.5μm. The refractive index of the cross-linkable polymer is 1.47, and the refractive index of the beads is 1.42. The refractive index is a value measured for a light source having a wavelength of 350 nm to 1450 nm at a temperature of 25°C using an Abbe refractometer.

The pressure-sensitive adhesive composition was compounded with a mixer (stirrer) for 50 minutes, and then applied to a first release film (MRP38, Mitsubishi Plastics) with a thickness of $38\mu m$ to have a thickness of about $22\mu m$ after drying, and dried at a temperature of 80°C for 3 minutes to form a scattering pressure-sensitive adhesive. On the scattering pressure-sensitive adhesive formed on the first release film, a second release film (MRP, Mitsubishi Plastics) having a peel force different from that of the first release film and a thickness of $38\mu m$ was laminated. After lamination, it was irradiated with light (about 150 mJ/250mW) for about 15 seconds by a mercury high-pressure lamp (light quantity of 80W) to manufacture a pressure-sensitive adhesive film.

A first protective film (TAC film) with a thickness of $65\mu m$ was laminated on one side of a polarizer (iodine-dyed PVA-based stretched film) with a thickness of $25\mu m$, and a second protective film (TAC film) with a thickness of $45\mu m$ was laminated on the other side of the polarizer. A low-reflective layer having an average reflective index of about 2% for a wavelength of 380nm to 780nm was formed on one side of the first protective film, and surface-treated. A quarter wavelength plate (liquid crystal layer) was formed on one side of the second protective film. The second release film was removed from the above-manufactured pressure-sensitive adhesive film, and then a polarizing plate was manufactured by laminating the scattering pressure-sensitive adhesive thereon to be attached to the quarter wavelength plate.

**Example 2**

A polarizing plate was manufactured in the same method as in Example 1, except that the bead content was changed to 3 parts by weight.

**Example 3**

A polarizing plate was manufactured in the same method as in Example 1, except that the bead content was changed to 4.5 parts by weight.

**Example 4**

100 parts by weight of a mixture (AD-705, LG Chem) of a cross-linkable polymer and a radically polymerizable trifunctional compound, 0.26 parts by weight of a curing agent (T-39M, Soken), 1.76 parts by weight of an initiator (AD-PI2, LG Chem), 0.05 parts by weight of a silane coupling agent (AD-M812, LG Chem), 1.10 parts by weight of an antistatic agent (HQ115, 3M), and 3.35 parts by weight of beads (TSR 9000, Momentive) were put into a reaction vessel, and then a solvent (ethyl acetate) was introduced thereto to prepare a pressure-sensitive adhesive composition. The cross-linkable polymer is a polymer of 99 parts by weight of BA (butyl acrylate) and 1 part by weight of 4-HBA (4-hydroxybutyl acrylate). The radically polymerizable trifunctional compound is a trifunctional acrylate. The beads comprise a silicone resin, and are spherical particles having an average particle diameter (D50) of about $2.2\mu m \sim 2.5\mu m$. The refractive index of the cross-linkable polymer is 1.47, and the refractive index of the beads is 1.42. The refractive index is a value measured for a light source having a wavelength of 350 nm to 1450 nm at a temperature of 25°C using an Abbe refractometer.

The pressure-sensitive adhesive composition was compounded with a mixer (stirrer) for 50 minutes, and then applied to a first release film (MRP38, Mitsubishi Plastics) with a thickness of $38\mu m$ to have a thickness of about $22\mu m$ after drying, and dried at a temperature of 80°C for 3 minutes to form a scattering pressure-sensitive adhesive layer. On the scattering pressure-sensitive adhesive layer formed on the first release film, a second release film (MRP38, Mitsubishi Plastics) having a peel force different from that of the first release film and a thickness of $38\mu m$ was laminated. After lamination, it was irradiated with light (about 150 mJ/250mW) for about 15 seconds by a mercury high-pressure lamp (light quantity of 80W) to manufacture a pressure-sensitive adhesive film.

A first protective film (TAC film) with a thickness of $65\mu m$ was laminated on one side of a polarizer (iodine-dyed PVA-based stretched film) with a thickness of $25\mu m$, and a second protective film (TAC film) with a thickness of $45\mu m$ was laminated on the other side of the polarizer. A low-reflective layer having an average reflective index of about 2% for a wavelength of 380nm to 780nm was formed on one side of the first protective film, and surface-treated. A quarter wavelength plate (liquid crystal layer) was formed on one side of the second protective film. The second release film was removed from the above-manufactured pressure-sensitive adhesive film, and then a polarizing plate was manufactured by laminating the scattering pressure-sensitive adhesive layer thereon to be attached to the quarter wavelength plate.

**Example 5**

A polarizing plate was manufactured in the same method as in Example 4, except that the bead content was changed to 6 parts by weight relative to 100 parts by weight of the mixture (AD-705, LG Chem) of the cross-linkable polymer and the radically polymerizable trifunctional compound.

### Example 6

A polarizing plate was manufactured in the same method as in Example 4, except that the beads were changed to spherical particles (Tospearl 145, Momentive) with an average particle diameter (D50) of about $4.5\mu m$, and the bead content was changed to 4.50 parts by weight relative to 100 parts by weight of the mixture (AD-705, LG Chem) of the cross-linkable polymer and the radically polymerizable trifunctional compound.

### Example 7

A polarizing plate was manufactured in the same method as in Example 4, except that the beads were changed to spherical particles (Tospearl 145, Momentive) with an average particle diameter (D50) of about $4.5\mu m$, and the bead content was changed to 6 parts by weight relative to 100 parts by weight of the mixture (AD-705, LG Chem) of the cross-linkable polymer and the radically polymerizable trifunctional compound.

### Example 8

A polarizing plate was manufactured in the same method as in Example 4, except that the bead content was changed to 3 parts by weight relative to 100 parts by weight of the mixture (AD-705, LG Chem) of the cross-linkable polymer and the radically polymerizable trifunctional compound.

### Comparative Example 1

100 Parts by weight of an acrylic polymer (LC-6BB, Soken), 0.01 parts by weight of a curing agent (T-743L, Soken), 0.45 parts by weight of a curing agent (T-706BB, Soken), 0.02 parts by weight of a silane coupling agent (T-789J, Soken), 0.29 parts by weight of an antistatic agent (FC4400, 3M) and 4 parts by weight of beads (Tospearl 145, Momentive) were put into a reaction vessel, and a solvent (ethyl acetate) was introduced thereto in an amount of 20 parts by weight relative to 100 parts by weight of the acrylic polymer (LC-6BB) to prepare a pressure-sensitive adhesive composition. The acrylic polymer is a polymer of 94 parts by weight of BA (butyl acrylate) and 4 parts by weight of AA (acrylic acid). The beads comprise a silicone resin, and are spherical particles having an average particle diameter (D50) of about $4.5\mu m$. The refractive index of the acrylic polymer is 1.46, and the refractive index of the beads is 1.42. The refractive index is a value measured for a light source having a wavelength of 350 nm to 1450 nm at a temperature of 25°C using an Abbe refractometer.

The pressure-sensitive adhesive composition was compounded with a mixer (stirrer) for 50 minutes, and then applied to a first release film (MRP38, Mitsubishi Plastics) with a thickness of $38\mu m$ to have a thickness of about $22\mu m$ after drying, and dried at a temperature of 80°C for 3 minutes to form a scattering pressure-sensitive adhesive. On the scattering pressure-sensitive adhesive formed on the first release film, a second release film (MRP, Mitsubishi Plastics) having a peel force different from that of the first release film and a thickness of $38\mu m$ was laminated.

A first protective film (TAC film) with a thickness of $65\mu m$ was laminated on one side of a polarizer (iodine-dyed PVA-based stretched film) with a thickness of $25\mu m$, and a second protective film (TAC film) with a thickness of $45\mu m$ was laminated on the other side of the polarizer. A low-reflective layer having an average reflective index of about 2% for a wavelength of 380nm to 780nm was formed on one side of the first protective film, and surface-treated. A quarter wavelength plate (liquid crystal layer) was formed on one side of the second protective film. The second release film was removed from the above-manufactured pressure-sensitive adhesive film, and then a polarizing plate was manufactured by laminating the pressure-sensitive adhesive thereon to be attached to the quarter wavelength plate.

### Comparative Example 2

A polarizing plate was manufactured in the same method as in Example 1, except that beads were not added.

### Comparative Example 3

A polarizing plate was manufactured in the same method as in Example 4, except that beads were not added.

**Comparative Example 4**

A polarizing plate was manufactured in the same method as in Example 4, except that the beads were changed to spherical particles (Tospearl 145, Momentive) having an average particle diameter (D50) of about 4.5μm and a refractive index of 1.42, and the bead content was changed to 0.60 parts by weight relative to 100 parts by weight of the mixture (AD-705, LG Chem) of the cross-linkable polymer and the radically polymerizable trifunctional compound. The beads (Tospearl 145, Momentive) comprise a silicone resin, and have a refractive index of 1.42.

**Comparative Example 5**

A polarizing plate was manufactured in the same method as in Example 4, except that the bead content was changed to 0.5 parts by weight relative to 100 parts by weight of the mixture (AD-705, LG Chem) of the cross-linkable polymer and the radically polymerizable trifunctional compound.

After measuring the storage elastic moduli and hazes for Examples 1 to 8 and Comparative Examples 1 to 5, the results were described in Table 1.

**Measurement Example 1. Haze measurement**

After the polarizing plate was cut to a size of width × length=5 cm×5 cm to prepare a sample, the haze was measured at 25°C using a haze meter (HM-150, Murakami color research laboratory). The haze is a value measured for light having a wavelength of 380 nm to 780 nm.

**Measurement Example 2. Storage elastic modulus measurement**

A sample was prepared to have a size of width × length=15cm×20cm by folding and laminating a scattering pressure-sensitive adhesive layer in 16 layers, and then a storage elastic modulus was measured under conditions of a temperature of 25°C and 50% strain using ARES-G2 (TA Instruments) equipment, and a value at a frequency of 1 rad/sec was extracted.

[Table 1]

|  | Haze (%) | Storage elastic modulus (Pa) |
|---|---|---|
| Example 1 | 28% | 152,330 |
| Example 2 | 20% | 154,427 |
| Example 3 | 35% | 151,987 |
| Example 4 | 30.5% | 151987 |
| Example 5 | 40.0% | 152023 |
| Example 6 | 30.0% | 152937 |
| Example 7 | 34.0% | 154402 |
| Example 8 | 21.5% | 154427 |
| Comparative Example 1 | 26% | 86,752 |
| Comparative Example 2 | 1% | 153,426 |
| Comparative Example 3 | 0.5% | 153422 |
| Comparative Example 4 | 5.0% | 156321 |
| Comparative Example 5 | 5.0% | 152330 |

For Examples 1 to 8 and Comparative Examples 1 to 5, the glass pushing distance, the presence or absence of staining, heat-resistance reliability, and heat and moisture resistance reliability were evaluated, and the results were described in Tables 2 and 3.

**Measurement Example 3. Glass pushing distance (creep) measurement**

The polarizing plate was cut to a size of 10 mm × 100 mm in width × length. After peeling the first release film from the polarizing plate, a specimen was prepared by attaching the pressure-sensitive adhesive layer of the polarizing plate to an area of 10mm× 10mm in width × length in the center of a glass plate (soda lime glass) having a size of 30mm×40mm×0.8mm in width × length × thickness so that it is in contact with the glass plate. After the specimen was defoamed at 50°C and 5 atm for 15 minutes, the pushing distance was measured. Specifically, the specimen was loaded into a texture analyzer (Stable micro system, XT plus) and the polarizing plate part and the glass plate part were fixed. When the polarizing plate was pulled in one direction with a force of 800 gf for 1000 seconds, the distance (unit: $\mu$m) at which the polarizing plate was pushed from the glass substrate was measured. In general, it was in saturation (a state where the pushing distance does not increase further and comes out uniformly), and in this experiment, the pushing distance at the final 1000 seconds was measured and described in Table 2 below. It means that the lower the glass pushing distance, the higher the hardness of the sample.

**Evaluation Example 1. Presence or absence of staining**

After cutting the polarizing plate to a size of A4, the first release film was removed from the polarizing plate, and then attached to an OLED panel (Micro lens array OLED, LGD), and the OLED panel was operated, and then it was visually observed whether stains occurred.

**Evaluation Example 2. Heat-resistance reliability, and moisture-and-heat-resistance reliability evaluation (A)**

The polarizing plate was cut to width × length = 160mm×90mm, and then attached to a glass plate (soda lime glass) with a size of A4 and defoamed, thereby preparing a sample. The sample was put into a chamber maintained under heat-resistance reliability (temperature 80°C) and moisture-and-heat-resistance reliability (temperature 60°C, 90% relative humidity) conditions, and then maintained for 500 hours. After observing whether or not bubbles were generated in the sample, the reliability was evaluated based on the following criteria.

◎: no bubble occurrence

O: less than 5 bubbles

Δ: 5 or more bubbles

×: polarizing plate lifting occurrence

[Table 2]

| | | Glass pushing distance ($\mu$m) | Staining occurrence | Heat-resistance reliability | Moisture-and-heat-resistance reliability |
|---|---|---|---|---|---|
| Example | 1 | 185 | Non-occurrence | ◎ | ◎ |
| | 2 | 189 | Slight occurrence | ◎ | ◎ |
| | 3 | 201 | Non-occurrence | ◎ | ◎ |
| | 4 | 201 | Non-occurrence | ◎ | ◎ |
| | 5 | 192 | Non-occurrence | ◎ | ◎ |
| | 6 | 200 | Non-occurrence | ◎ | ◎ |
| | 7 | 202 | Non-occurrence | ◎ | ◎ |
| | 8 | 189 | Slight occurrence | ◎ | ◎ |

(continued)

| | | Glass pushing distance ($\mu$m) | Staining occurrence | Heat-resistance reliability | Moisture-and-heat-resistance reliability |
|---|---|---|---|---|---|
| Comparative Example | 1 | 230 | Non-occurrence | ◎ | ◎ |
| | 2 | 190 | Strong occurrence | ◎ | ◎ |
| | 3 | 194 | Occurrence | ◎ | ◎ |
| | 4 | 198 | Occurrence | ◎ | ◎ |
| | 5 | 185 | Occurrence | ◎ | ◎ |

**Evaluation Example 3. Heat-resistance reliability, and moisture-and-heat-resistance reliability evaluation (B)**

The heat-resistance change rate ($\Delta$Ha) of the following Equation 1 and the moisture-and-heat-resistance change rate ($\Delta$Hb) of the following Equation 2 were measured, and the results were described in Table 3 below. Specifically, the polarizing plate was cut into width $\times$ length=47mm$\times$47mm, and then attached to a glass plate (soda lime glass) having a size of 50mm$\times$50mm$\times$0.8mm in width $\times$ length $\times$ thickness and defoamed, thereby preparing a sample. The sample was put into a chamber maintained under heat-resistance reliability (temperature 80°C) and moisture-and-heat-resistance reliability (temperature 60°C, 90% relative humidity) conditions, and maintained for 500 hours. The haze measured at 25°C before introduction into the chamber is $H_1$ of Equation 1 and $H_3$ of Equation 2 below, and the haze measured after 500-hour maintenance under the condition of heat-resistance reliability (temperature 80°C) of the chamber is $H_2$ of Equation 1, and the haze measured after 500-hour maintenance under the condition of moisture-and-heat-resistance reliability (temperature of 60°C, 90% relative humidity) is $H_4$ of Equation 2.

[Equation 1]

$$\Delta Ha = (H_1 - H_2)/H_1 \times 100\%$$

[Equation 2]

$$\Delta Hb = (H_3 - H_4)/H_3 \times 100\%$$

[Table 3]

| | | Before heat-resisting introduction | After heat-resisting for 500 hrs | Before moisture-and-heat-resisting introduction | After moisture-and-heat-resisting for 500 hrs | Heat-resistance change rate | Moisture-and-heat-resistance change rate |
|---|---|---|---|---|---|---|---|
| Example | 1 | 28.1% | 28.6% | 27.6% | 27.2% | 1.78% | 1.45% |
| | 2 | 12.2% | 12.4% | 12.5% | 12.3% | 1.64% | 1.60% |
| | 3 | 35.5% | 36.1% | 35.4% | 35.3% | 1.69% | 0.28% |
| | 4 | 30.2 | 30.6 | 30.4 | 30.3 | 1.32% | 0.33% |
| | 5 | 35.4 | 35.8 | 35.6 | 35.3 | 1.13% | 0.84% |
| | 6 | 29.7 | 30.2 | 31.2 | 30.7 | 1.68% | 1.60% |
| | 7 | 36.1 | 36.6 | 35.8 | 35.3 | 1.39% | 1.40% |
| | 8 | 21.7 | 22.1 | 21.7 | 21.3 | 1.84% | 1.84% |

(continued)

| | | Before heat-resisting introduction | After heat-resisting for 500 hrs | Before moisture-and-heat-resisting introduction | After moisture-and-heat-resisting for 500 hrs | Heat-resistance change rate | Moisture-and-heat-resistance change rate |
|---|---|---|---|---|---|---|---|
| Comparative Example | 1 | 26.2% | 27% | 26.5% | 25.8% | 3.05% | 2.64% |
| | 2 | 0.2% | 0.2% | 0.2% | 0.2% | 0.00% | 0.00% |
| | 3 | 0.2 | 0.2 | 0.4 | 0.4 | 0.00% | 0.00% |
| | 4 | 4.9 | 4.9 | 5.1 | 5.0 | 0.00% | 1.96% |
| | 5 | 5.1 | 5.2 | 5.1 | 5.0 | 1.96% | 1.96% |

For Examples 4 to 8 and Comparative Examples 3 to 5, the sparkling phenomenon and camera recognition were evaluated, and the results were described in Table 4.

**Evaluation Example 4. Sparkling phenomenon evaluation**

After cutting the polarizing plate to a size of A4, the first release film was removed from the polarizing plate, and then attached to a monitor with a green background, and then it was visually observed whether there was a sparkling (glittering) phenomenon in a dark room environment at room temperature. According to the degree of the sparkling phenomenon, the grade was evaluated as follows.

Lv 0: no sparkling phenomenon

Lv 1: slight sparkling phenomenon

Lv 2: weak sparkling phenomenon

Lv 3: medium sparkling phenomenon

Lv 4: medium-strong sparkling phenomenon

Lv 5: strong sparkling phenomenon

**Evaluation Example 5. Camera recognition evaluation**

After cutting the polarizing plate to a size of A4, an arbitrary red line was drawn on the release film surface in the polarizing plate, and the distribution of beads was observed around the line with an optical microscope ($\times 50$ magnification). If the distribution of beads is high, the camera recognizes the beads upon the attaching process and catches the reference line incorrectly, whereby attaching errors may occur.

[Table 4]

| | Sparkling degree | Camera recognition |
|---|---|---|
| Example 4 | Lv 1 | Unrecognized |
| Example 5 | Lv 2 | Unrecognized |
| Example 6 | Lv 5 | Recognized |
| Example 7 | Lv 5 | Recognized |
| Example 8 | Lv 1 | Unrecognized |
| Comparative Example 3 | Lv 0 | Unrecognized |
| Comparative Example 4 | Lv 4 | Recognized |
| Comparative Example 5 | Lv 1 | Unrecognized |

**Claims**

1. A polarizing plate comprising a polarizer and a scattering pressure-sensitive adhesive layer present on one side of the polarizer, wherein the scattering pressure-sensitive adhesive layer has a storage elastic modulus of 120,000 Pa or more at a temperature of 25°C and a frequency of 1 rad/sec, and the polarizing plate has a haze of 12% or more.

2. The polarizing plate according to claim 1, wherein the scattering pressure-sensitive adhesive layer comprises a pressure-sensitive adhesive resin and beads.

3. The polarizing plate according to claim 2, wherein the scattering pressure-sensitive adhesive layer comprises a pressure-sensitive adhesive resin, and the pressure-sensitive adhesive resin has an IPN (interpenetrating network) cross-linked structure.

4. The polarizing plate according to claim 3, wherein the IPN cross-linked structure comprises a first cross-linked structure formed by a cross-linking reaction of a cross-linkable polymer and a polyfunctional cross-linking agent and a second cross-linked structure formed by a polymerization reaction of a radically polymerizable compound.

5. The polarizing plate according to claim 4, wherein the difference (A-B) between the refractive index (A) of the cross-linkable polymer and the refractive index (B) of the beads is in a range of 0.05 to 0.1.

6. The polarizing plate according to claim 2, wherein the beads comprise a silicone resin.

7. The polarizing plate according to claim 2, wherein the beads are included in a range of 2 parts by weight to 10 parts by weight relative to 100 parts by weight of the pressure-sensitive adhesive resin.

8. The polarizing plate according to claim 1, wherein the scattering pressure-sensitive adhesive layer has a thickness in a range of $15\mu$m to $25\mu$m.

9. The polarizing plate according to claim 1, wherein the scattering pressure-sensitive adhesive layer has a glass pushing distance measured at 800 gf for 1000 seconds in a range of $150\mu$m to $210\mu$m.

10. The polarizing plate according to claim 1, wherein the polarizing plate has a haze change rate $\Delta$Ha of Equation 1 after resisting heat and a haze change rate $\Delta$Hb of Equation 2 after resisting moisture and heat of 2% or less, respectively:

$$[\text{Equation 1}]$$

$$\Delta Ha = (H_1 - H_2)/H_1 \times 100\%$$

$$[\text{Equation 2}]$$

$$\Delta Hb = (H_3 - H_4)/H_3 \times 100\%$$

wherein, in Equation 1, $H_1$ is the haze of the polarizing plate at a temperature of 25°C, and $H_2$ is the haze of the polarizing plate after storage at a temperature of 80°C for 500 hours; and in Equation 2, $H_3$ is the haze of the polarizing plate at a temperature of 25°C, and $H_4$ is the haze of the polarizing plate after storage at a temperature of 60°C and 90% relative humidity for 500 hours.

11. The polarizing plate according to claim 1, further comprising a polarizer protective film present on one or both sides of the polarizer.

12. The polarizing plate according to claim 1, further comprising a retardation layer between the polarizer and the scattering pressure-sensitive adhesive layer.

13. An OLED (organic light emitting diode) display device comprising an OLED display panel and the polarizing plate of claim 1 disposed on one side of the OLED display panel.

14. The OLED display device according to claim 13, wherein the polarizing plate is disposed on the light emission side of the OLED display panel.

[Figure 1]

```
┌──────────────────────────────┐
│                              │～600
├──────────────────────────────┤
│                              │～500
├──────────────────────────────┤
│                              │～400
├──────────────────────────────┤
│                              │～300
├──────────────────────────────┤
│                              │～200
├──────────────────────────────┤
│                              │～100
└──────────────────────────────┘
```

[Figure 2]

```
┌──────────────────────────────┐
│                              │～600
├──────────────────────────────┤
│                              │～500
├──────────────────────────────┤
│                              │～400
├──────────────────────────────┤
│                              │～300
├──────────────────────────────┤
│                              │～100
└──────────────────────────────┘
```

[Figure 3]

```
┌──────────────────────────────┐
│                              │～600
├──────────────────────────────┤
│                              │～500
├──────────────────────────────┤
│                              │～400
├──────────────────────────────┤
│                              │～700
├──────────────────────────────┤
│                              │～100
└──────────────────────────────┘
```

## INTERNATIONAL SEARCH REPORT

| International application No. |
| --- |
| **PCT/KR2022/015762** |

**A.    CLASSIFICATION OF SUBJECT MATTER**

**G02B 5/30**(2006.01)i; **G02B 5/02**(2006.01)i; **B32B 7/023**(2019.01)i; **B32B 7/12**(2006.01)i; **H10K 59/00**(2023.01)i; **H10K 50/80**(2023.01)i; **H05B 33/02**(2006.01)i

According to International Patent Classification (IPC) or to both national classification and IPC

**B.    FIELDS SEARCHED**

Minimum documentation searched (classification system followed by classification symbols)

G02B 5/30(2006.01); B32B 7/12(2006.01); C09J 7/20(2018.01); G02F 1/1335(2006.01); G02F 1/13363(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 편광(polarization), 저장 탄성률(storage modulus), 헤이즈(haze), 점착제(adhesive), 비드(bead)

**C.    DOCUMENTS CONSIDERED TO BE RELEVANT**

| Category* | Citation of document, with indication, where appropriate, of the relevant passages | Relevant to claim No. |
| --- | --- | --- |
| X | KR 10-2010-0058462 A (SUMITOMO CHEMICAL COMPANY LIMITED et al.) 03 June 2010 (2010-06-03)<br>    See paragraphs [0032]-[0093] and [0230] and figures 1-2. | 1-14 |
| A | KR 10-2018-0062950 A (NITTO DENKO CORPORATION) 11 June 2018 (2018-06-11)<br>    See paragraphs [0020]-[0200] and figures 1-4. | 1-14 |
| A | KR 10-2011-0098688 A (LG CHEM, LTD.) 01 September 2011 (2011-09-01)<br>    See paragraphs [0072]-[0154] and figures 1-4. | 1-14 |
| A | KR 10-2016-0102408 A (NITTO DENKO CORPORATION) 30 August 2016 (2016-08-30)<br>    See paragraphs [0044]-[0351] and figures 1a-4. | 1-14 |
| A | KR 10-2013-0117542 A (NATURAL & HUMAN CO., LTD.) 28 October 2013 (2013-10-28)<br>    See paragraphs [0021]-[0038] and figures 1-4. | 1-14 |

☐ Further documents are listed in the continuation of Box C.      ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **31 January 2023** | **31 January 2023** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

INTERNATIONAL SEARCH REPORT
Information on patent family members

International application No.

**PCT/KR2022/015762**

| Patent document cited in search report | | | Publication date (day/month/year) | Patent family member(s) | | | Publication date (day/month/year) |
|---|---|---|---|---|---|---|---|
| KR | 10-2010-0058462 | A | 03 June 2010 | CN | 101784923 | A | 21 July 2010 |
| | | | | CN | 101784923 | B | 07 March 2012 |
| | | | | JP | 5571953 | B2 | 13 August 2014 |
| | | | | KR | 10-1501794 | B1 | 11 March 2015 |
| | | | | TW | 200928463 | A | 01 July 2009 |
| | | | | TW | I453472 | B | 21 September 2014 |
| | | | | WO | 2009-025360 | A1 | 26 February 2009 |
| KR | 10-2018-0062950 | A | 11 June 2018 | CN | 108169833 | A | 15 June 2018 |
| | | | | CN | 108169833 | B | 23 July 2021 |
| | | | | JP | 2018-091974 | A | 14 June 2018 |
| | | | | JP | 6934296 | B2 | 15 September 2021 |
| | | | | TW | 201826583 | A | 16 July 2018 |
| | | | | TW | I747995 | B | 01 December 2021 |
| KR | 10-2011-0098688 | A | 01 September 2011 | CN | 102859403 | A | 02 January 2013 |
| | | | | CN | 102859403 | B | 20 April 2016 |
| | | | | EP | 2527885 | A2 | 28 November 2012 |
| | | | | EP | 2527885 | B1 | 29 September 2021 |
| | | | | JP | 2013-520705 | A | 06 June 2013 |
| | | | | JP | 2016-105172 | A | 09 June 2016 |
| | | | | JP | 6053524 | B2 | 27 December 2016 |
| | | | | JP | 6112372 | B2 | 12 April 2017 |
| | | | | KR | 10-1314489 | B1 | 07 October 2013 |
| | | | | TW | 201144398 | A | 16 December 2011 |
| | | | | TW | I484012 | B | 11 May 2015 |
| | | | | US | 2012-0314160 | A1 | 13 December 2012 |
| | | | | US | 9791608 | B2 | 17 October 2017 |
| | | | | WO | 2011-105874 | A2 | 01 September 2011 |
| | | | | WO | 2011-105874 | A3 | 12 January 2012 |
| KR | 10-2016-0102408 | A | 30 August 2016 | CN | 105849598 | A | 10 August 2016 |
| | | | | CN | 105849598 | B | 07 February 2020 |
| | | | | JP | 2015-143848 | A | 06 August 2015 |
| | | | | JP | 6488125 | B2 | 20 March 2019 |
| | | | | KR | 10-2179611 | B1 | 17 November 2020 |
| | | | | TW | 201531752 | A | 16 August 2015 |
| | | | | TW | I655461 | B | 01 April 2019 |
| | | | | WO | 2015-099022 | A1 | 02 July 2015 |
| KR | 10-2013-0117542 | A | 28 October 2013 | None | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020090122138